# EUROPEAN PATENT APPLICATION

(11) **EP 4 576 962 A1**
(43) Date of publication of application: **25.06.2025**
(21) Application number: 23858782.8
(22) Date of filing: 05.06.2023
(51) Int. Cl.: H05K 7/20

(54) **HEAT SINK AND ELECTRONIC DEVICE**

(30) Priority: 01.09.2022 CN 202211064954
(71) Applicant: ZTE CORPORATION, Shenzhen, Guangdong 518057 (CN)
(72) Inventor: DUAN, Zhiwei, Shenzhen, Guangdong 518057 (CN); SUN, Zhen, Shenzhen, Guangdong 518057 (CN); XU, Qingsong, Shenzhen, Guangdong 518057 (CN)
(74) Representative: Ziebig Hengelhaupt Intellectual Property Attorneys Patentanwaltskanzlei PartGmbB
(86) International application number: PCT/CN2023/098432
(87) International publication number: WO 2024/045743

(57) **Abstract**

Disclosed in the embodiments of the present application are a heat sink and an electronic device. The disclosed heat sink comprises a base, a condensation portion and an isolation portion, wherein the base is provided with an evaporation cavity, and a gaseous working medium output port and a liquid working medium backflow port, which are both in communication with the evaporation cavity; the isolation portion is provided with a gaseous working medium input channel; a first end portion of the gaseous working medium input channel is in communication with the gaseous working medium output port; the isolation portion is arranged in the condensation portion; a liquid working medium backflow channel is formed between the outer surface of the isolation portion and the inner wall of the condensation portion; a second end portion of the gaseous working medium input channel is in communication with a first end portion of the liquid working medium backflow channel; a second end portion of the liquid working medium backflow channel is in communication with the liquid working medium backflow port; and the isolation portion isolates the gaseous working medium output port from the liquid working medium backflow port.

## Description

### CROSS-REFERENCE TO RELATED APPLICATIONS

The present application claims priority to Chinese Patent Application No. 202211064954.X, filed to the China Patent Office on September 1, 2022 and entitled "HEAT SINK AND ELECTRONIC DEVICE", which is incorporated herein by reference in its entirety.

### TECHNICAL FIELD

The present application relates to the technical field of heat sink design, in particular to a heat sink and an electronic device.

### BACKGROUND

With development of technologies, there are more and more functional devices integrated in equipment, which leads to higher and higher quantity of heat produced by these equipment, and then affects the working performance. In order to avoid too high temperature of the equipment during working, related equipment is usually configured with a heat sink which realizes fast heat transfer by using an evaporation-condensation cycle of a working medium in the heat sink and finally achieves the purpose of heat dissipation.

A 3-Dimension vapor chamber (3DVC) heat sink is a two-phase heat sink capable of dissipating heat in a three-dimensional space, and compared with one-dimensional heat dissipation of a heat pipe and two-dimensional heat dissipation of a vapor chamber, the 3DVC heat sink can perform heat dissipation in a more-dimensional space, and thus has a high heat dissipation performance.

During an actual heat dissipation process, a working medium is heated and evaporated in an evaporation cavity to become a gaseous state and is condensed in a condensation cavity to become a liquid state, and fast heat transfer in the whole 3DVC heat sink is implemented through the evaporation-condensation cycle of the working medium. However, during a process that a gaseous working medium flows into the condensation cavity and a liquid working medium flows from the condensation cavity into the evaporation cavity, the flowing direction of the gaseous working medium is opposite to that of the liquid working medium, so that shear force is formed, respective flowing of the liquid working medium and the gaseous working medium are finally affected, and a heat dissipation effect is reduced. Accordingly, the 3DVC heat sink in some cases still has a problem of low heat dissipation efficiency.

In addition to the 3DVC heat sink, other types of heat sinks also have the same problem.

### SUMMARY

An objective of embodiments of the present application is to disclose a heat sink and an electronic device, for solving the problem of poor heat dissipation effect of a heat sink in some cases.

To solve the above technical problem, the embodiments of the present application disclose the following technical solution.

A heat sink includes a base, a condensation portion and an isolation portion, wherein the base is provided with an evaporation cavity, and a gaseous working medium output port and a liquid working medium backflow port which are both in communication with the evaporation cavity; the isolation portion is provided with a gaseous working medium input channel, and a first end portion of the gaseous working medium input channel is in communication with the gaseous working medium output port; the isolation portion is arranged in the condensation portion, and a liquid working medium backflow channel is formed between an outer surface of the isolation portion and an inner wall of the condensation portion; and a second end portion of the gaseous working medium input channel is in communication with a first end portion of the liquid working medium backflow channel, a second end portion of the liquid working medium backflow channel is in communication with the liquid working medium backflow port, and the isolation portion isolates the gaseous working medium output port from the liquid working medium backflow port.

An electronic device includes a heat source device and a heat sink, a base is arranged on the heat source device, and the heat sink is the heat sink described above.

### BRIEF DESCRIPTION OF DRAWINGS

In order to more clearly describe technical solutions in one or more embodiments of the present specification or in the related art, the accompanying drawings needed by the description in the embodiments or in the related art will be briefly introduced below. It is obvious that the accompanying drawings in the following description are merely some embodiments recited in one or more embodiments of the present specification. For those ordinarily skilled in the art, other accompanying drawings can be obtained based on these accompanying drawings without creative effort.

FIG. 1 is a stereoscopic schematic diagram of a heat sink disclosed by an embodiment of the present application.

FIG. 2 is an explosive schematic diagram of a base disclosed by an embodiment of the present application.

FIG. 3 is a schematic diagram of a first cover plate disclosed by an embodiment of the present application.

FIG. 4 is a sectional view of a heat sink disclosed by an embodiment of the present application.

FIG. 5 is a sectional view of a heat sink disclosed by an embodiment of the present application from a perspective.

FIG. 6 is a sectional view of a heat sink disclosed by an embodiment of the present application from another perspective.

Descriptions of reference numerals:
100-base, 110-fence, 120-base plate, 121-groove, 130-first cover plate, 140-support projection,
200-condensation portion, 210-condensation flat pipe, 220-second cover plate,
300-isolation portion,
400-capillary structure, 410-receding hole,
500-fin,
101-evaporation cavity, 102-gaseous working medium output port, 103-liquid working medium backflow port, 104-liquid working medium backflow channel, 105-gaseous working medium input channel, and 106-connecting channel.

### DETAILED DESCRIPTION

In order to make those skilled in the art better understand technical solutions in the present application, the technical solutions in the embodiments of the present application are described clearly and completely below with reference to the accompanying drawings in the embodiments of the present application. Apparently, the described embodiments are merely some embodiments but not all embodiments of the present application. All other embodiments obtained by those ordinarily skilled in the art based on the embodiments in the present application without making creative efforts should fall within the protection scope of the present application.

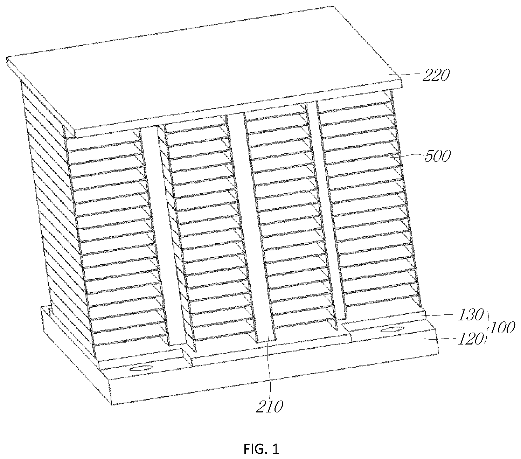

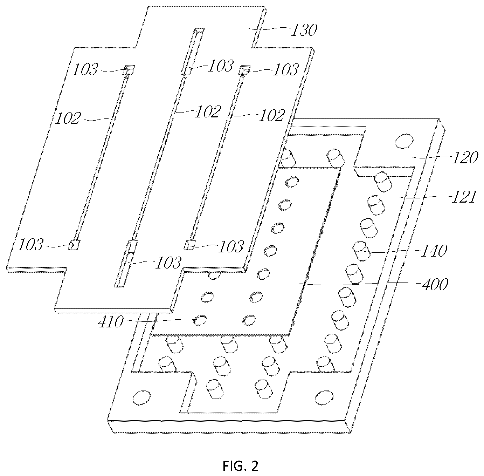

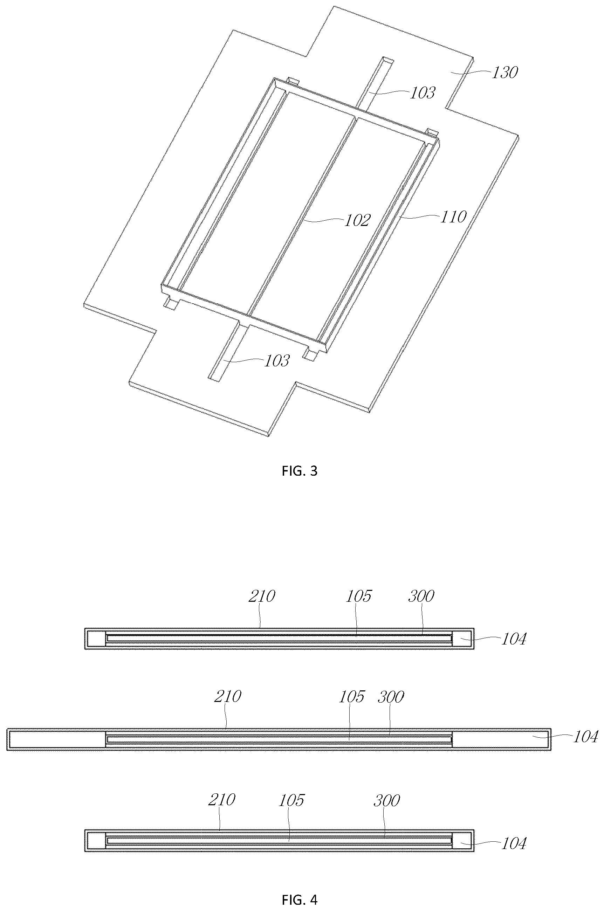

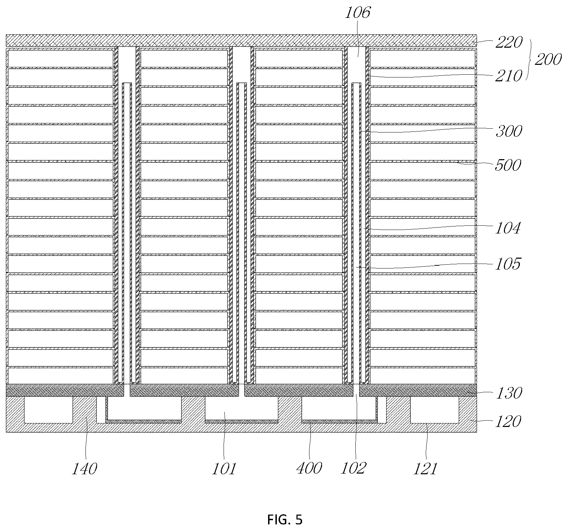

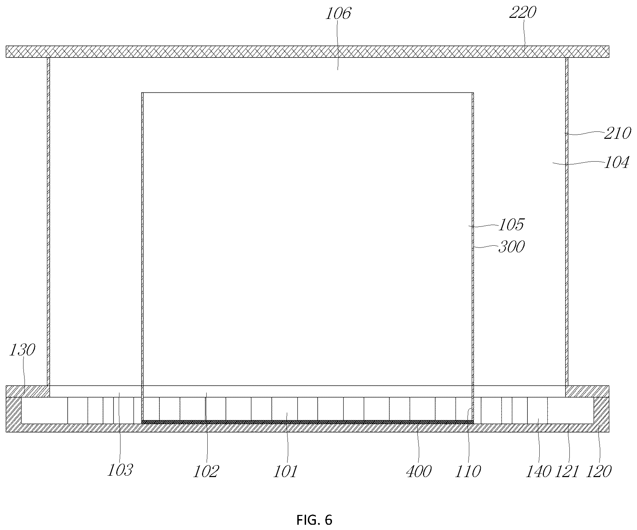

Please refer to FIG. 1 to FIG. 6, embodiments of the present application disclose a heat sink. The disclosed heat sink includes a base 100, a condensation portion 200 and an isolation portion 300.

The base 100 is a base portion of the heat sink and may serve as a mounting connection portion of the heat sink. When the heat sink is to be mounted on an object to be heat-dissipated, the base 100 may be connected with the object to be heat-dissipated, so as to achieve an assembling connection between the heat sink and the object to be heat-dissipated.

The base 100 not only plays a role in mounting and connecting, but also forms other structures. In the embodiment of the present application, the base 100 is provided with an evaporation cavity 101, a gaseous working medium output port 102 and a liquid working medium backflow port 103. The evaporation cavity 101 is a space for evaporating a liquid working medium, and in the evaporation cavity 101, the liquid working medium may be evaporated to form a gaseous working medium. Both the gaseous working medium output port 102 and the liquid working medium backflow port 103 are in communication with the evaporation cavity 101, and a gaseous working medium formed in the evaporation cavity 101 may be discharged out of the evaporation cavity 101 through the gaseous working medium output port 102, and then perform subsequent heat dissipation. In a case where the gaseous working medium is condensed to become liquid working medium again, the liquid working medium may finally flow back into the evaporation cavity 101 through the liquid working medium backflow port 103, and enter a next evaporation-condensation cycle.

The isolation portion 300 is provided with a gaseous working medium input channel 105, and a first end portion of the gaseous working medium input channel 105 is in communication with the gaseous working medium output port 102. A gaseous working medium outputted from the gaseous working medium output port 102 can enter the gaseous working medium input channel 105 through the first end portion of the gaseous working medium input channel 105.

The condensation portion 200 is arranged on the base 100. In some embodiments, the condensation portion 200 may be fixed to the base 100. The condensation portion 200 plays a role in condensation, and the condensation portion 200 usually directly contacts with the environment where the heat sink is located, so the temperature is lower. The isolation portion 300 is arranged in the condensation portion 200, and a liquid working medium backflow channel 104 is formed between an outer surface of the isolation portion 300 and an inner wall of the condensation portion 200. A second end portion of the gaseous working medium input channel 105 is in communication with a first end portion of the liquid working medium backflow channel 104, and a second end portion of the liquid working medium backflow channel 104 is in communication with the liquid working medium backflow port 103. In other words, the gaseous working medium output port 102, the gaseous working medium input channel 105, the liquid working medium backflow channel 104, the liquid working medium backflow port 103 and the evaporation cavity 101 are in communication in sequence, so as to form a working medium circulation structure. In some cases, the state of the working medium may change between a gaseous state and a liquid state during the process of flowing in the working medium circulation structure.

In the embodiment of the present application, the isolation portion 300 plays a role in isolation, the isolation portion 300 isolates the gaseous working medium input channel 105 from the liquid working medium backflow channel 104, the isolation portion 300 isolates the gaseous working medium output port 102 from the liquid working medium backflow port 103, so that the gaseous working medium outputted from the gaseous working medium output port 102 can be prevented from directly entering the liquid working medium backflow port 103, the liquid working medium about to enter the liquid working medium backflow port 103 can be also prevented from directly entering the gaseous working medium output port 102, and thus mutual interference between the liquid working medium and the gaseous working medium can be avoided.

In the working process of the heat sink, the liquid working medium is evaporated in the evaporation cavity 101 of the base 100 to become the gaseous working medium, and the gaseous working medium enters the first end portion of the gaseous working medium input channel 105 through the gaseous working medium output port 102 and then flows in the gaseous working medium input channel 105 to the second end portion of the gaseous working medium input channel 105, and enters the liquid working medium backflow channel 104 through the second end portion of the gaseous working medium input channel 105. As the temperature of the condensation portion 200 is lower, after entering the liquid working medium backflow channel 104, a gaseous working medium with a high temperature makes contact with the condensation portion 200 to be condensed and thus become the liquid working medium again. The liquid working medium finally returns into the evaporation cavity 101 through the second end portion of the liquid working medium backflow channel 104 and the liquid working medium backflow port 103, so as to perform a next cycle.

In this process, heat produced by the object to be heat-dissipated can be transformed from the liquid working medium to the gaseous working medium by heating the working medium by the base 100, and the working medium may absorb heat. Heat may be released when the gaseous working medium is cooled in the liquid working medium backflow channel 104 to become the liquid working medium, heat released by condensation is finally dissipated to the environment where the condensation portion 200 is located through the condensation portion 20, so as to achieve the purpose of heat dissipation. During this process, the heat sink transfers the heat produced by the object to be heat-dissipated into the environment where the heat sink is located through state change of the working medium, so as to achieve the purpose of dissipating the heat of the object to be heat-dissipated.

It can be known through the above working process of the heat sink that the gaseous working medium outputted from the evaporation cavity 101 may flow towards the liquid working medium backflow channel 104 through the gaseous working medium input channel 105, and the liquid working medium formed in the liquid working medium backflow channel 104 may flow back into the evaporation cavity 101 through the liquid working medium backflow port 103. During this process, the gaseous working medium with a higher temperature and the liquid working medium with a lower temperature respectively flow in the gaseous working medium input channel 105 and the liquid working medium backflow channel 104 which are isolated by the isolation portion 300, and do not make contact with each other, so that contact of the gaseous working medium and the liquid working medium during a flowing process can be avoided, flow interference caused by shear force between the gaseous working medium and the liquid working medium can be avoided, which ensures that the gaseous working medium and the liquid working medium flow without interference, and thus the heat dissipation effect can be improved. Thus, the heat sink disclosed by the embodiment of the present application can solve the problem of poor heat dissipation effect of the heat sink in some cases.

It needs to be noted that the first end portion of the gaseous working medium input channel 105 herein refers to an end portion adjacent to the evaporation cavity 101 of the gaseous working medium input channel 105. The second end portion of the gaseous working medium input channel 105 refers to an end portion away from the evaporation cavity 101 of the gaseous working medium input channel 105. The first end portion of the liquid working medium backflow channel 104 refers to an end portion away from the evaporation cavity 101of the liquid working medium backflow channel 104. The second end portion of the liquid working medium backflow channel 104 refers to an end portion adjacent to the evaporation cavity 101of the liquid working medium backflow channel 104.

As described above, the gaseous working medium may be outputted from inside of the evaporation cavity 101 through the gaseous working medium output port 102. The liquid working medium may flow back into the evaporation cavity 101 through the liquid working medium backflow port 103, namely, the gaseous working medium and the liquid working medium may exist in the evaporation cavity 101 at the same time. For avoiding excessive mutual interference, in an optional solution, the evaporation cavity 101 may have a liquid working medium gathering region and an evaporation region, and the liquid working medium gathering region and the evaporation region are two local spaces of the evaporation cavity 101. The evaporation region is in communication with the gaseous working medium output port 102, and the liquid working medium backflow port 103 is in communication with the liquid working medium gathering region. A capillary structure 400 is arranged in the evaporation region, and the capillary structure 400 can evaporate the liquid working medium in the evaporation region to form the gaseous working medium and then transport the gaseous working medium away from the gaseous working medium output port 102. The liquid working medium gathering region is in communication with the evaporation region, so that the liquid working medium which flows back into the evaporation cavity 101 can enter the evaporation region. By means of this partitioned arrangement, contact of the gaseous working medium and the liquid working medium can be reduced to a certain degree, and thus mutual interference is avoided.

In a further technical solution, the base 100 includes a fence 110, and the fence 110 is arranged in the evaporation cavity 101 and around the capillary structure 400. A space defined by the fence 110 is the evaporation region, the gaseous working medium output port 102 is located inside the fence 110, and both the liquid working medium backflow port 103 and the liquid working medium gathering region are located outside the fence 110. In this case, the fence 110 can better determine the boundary of the evaporation region, which facilitates accurate mounting of the capillary structure 400. Moreover, the fence 110 can restrain the gaseous working medium formed in the evaporation region from being dispersed excessively, which better facilitates the gaseous working medium flowing to the gaseous working medium output port 102 in a more centralized mode, and thus further improves the heat dissipation efficiency of the heat sink. The fence 110 can isolate the gaseous working medium output port 102 from the liquid working medium backflow port 103, so that the liquid working medium can be prevented from directly flowing back to the evaporation region, and unfavorable influence on evaporation is avoided. It needs to be noted that the fence 110 may not isolate the evaporation region from the liquid working medium gathering region completely.

The capillary structure 400 may be a metal powder sintered structural member, a metal fiber sintered structural member, metal foam, a form-relieved tooth structure, a micro-groove structure, or the like, which is not limited by the embodiment of the present application.

In the embodiment of the present application, the base 100 is provided with the evaporation cavity 101, so it may be considered that the base 100 is of a hollow structure. There are a variety of manners for realizing the hollow structure, for example, the base 100 may be formed by bending and sealing processes of a whole plate.

In a feasible embodiment, the base 100 may include a base plate 120 and a first cover plate 130, the base plate 120 may be provided with a groove 121, the first cover plate 130 is connected with the base plate 120, and the first cover plate 130 covers a groove opening of the groove 121. The evaporation cavity 101 is defined by the first cover plate 130 and the base plate 120, and in some cases, the evaporation cavity 101 is defined by a surface where the groove 121 is formed in the base plate 120 and the first cover plate 130. During specific manufacturing, the groove 121 may be formed in the base plate 120 in a manner of etching, machining and the like, then the first cover plate 130 covers the groove opening of the groove 121, and in some cases, sealant may be arranged between the first cover plate 130 and the base plate 120, thus a sealing connection between the first cover plate and the base plate is achieved, and the sealing performance of the evaporation cavity 101 is ensured. Such manner has the advantage of convenient manufacturing.

The fence 110 may be connected with the first cover plate 130, in this case, the fence 110 may be firstly connected with the first cover plate 130, and then the fence and the first cover plate 130 are mounted on the base plate 120 as a whole, which simplifies assembling. In an optional solution, the fence 110 and the first cover plate 130 may be of an integrated structure, and in this case, the fence 110 can further play a role in enhancing the strength of the first cover plate 130.

In some cases, the fence 110 may also be welded to the first cover plate 130, and the first cover plate 130 may be welded to the base plate 120. In order to improve the heat dissipation capacity, the base 100, the isolation portion 300 and the condensation portion 200 may be all made of a copper material, an aluminum material, or other materials with high heat dissipation performance.

The gaseous working medium output port 102 and the liquid working medium backflow port 103 may be formed in the base plate 120, or in the first cover plate 130, which is not limited by the embodiment of the present application. In a case where the gaseous working medium output port 102 and the liquid working medium backflow port 103 are formed in the first cover plate 130 and the fence 110 is connected with the first cover plate 130, a structure which needs machining or assembling can be arranged on the first cover plate 130 in a more centralized mode, which makes centralized machining convenient and thus improves the machining efficiency.

In the embodiment of the present application, both the isolation portion 300 and the condensation portion 200 may be mounted on the base 100. The isolation portion 300 and the condensation portion 200 may be fixed to the base 100. As the base 100 is of the hollow structure, there may be a problem of insufficient supporting strength. On such basis, in an optional solution, the base 100 may also include a plurality of support projections 140 distributed in an array, and the plurality of support projections 140 perform supporting between a bottom wall of the groove 121 and the first cover plate 130. It needs to be noted that the bottom wall of the groove 121 is distributed opposite to the first cover plate 130. The capillary structure 400 is provided with receding holes 410, the support projections 140 corresponding to the capillary structure 400 are arranged in the corresponding receding holes 410 in a penetrating mode, so that influence of the capillary structure 400 on distribution of the support projections 140 is avoided.

Meanwhile, in this case, the plurality of support projections 140 perform supporting between the first cover plate 130 and the base plate 120, so that the strength of the whole base 100 can be improved. In some cases, the plurality of support projections 140 can play a role in supporting the first cover plate 130, so that in a case where the isolation portion 300 and the condensation portion 200 are mounted on the first cover plate 130, deformation of the first cover plate 130 is relieved more effectively, and thus the first cover plate 130 can better support the isolation portion 300 and the condensation portion 200.

In order to reduce assembling operations, in an optional solution, the support projections 140 and the base plate 120 may be of an integrated structure. In some cases, the support projections 140 and the base plate 120 are of the integrated structure, so it may be considered that the support projections 140 are enhancing projections of the base plate 120, and thus the deformation resistance of the base plate 120 can be improved. In some cases, the support projections 140 and the base plate 120 may also be of a split structure, and are fixedly connected in an adhering, welding or other fixing modes.

In the embodiment of the present application, there may be one condensation portion 200 and one isolation portion 300. In some cases, there may be a plurality of condensation portions 200 and a plurality of isolation portions 300, which are distributed at intervals. The plurality of condensation portions 200 and the plurality of isolation portions 300 are in one-to-one correspondence, so as to form a plurality of gaseous working medium input channels 105 and a plurality of liquid working medium backflow channels 104. In this way, the heat dissipation capacity of the heat sink can be improved.

Optionally, the plurality of condensation portions 200 are arranged on the base 100 at intervals, each liquid working medium backflow channel 104 is in communication with the corresponding liquid working medium backflow port 103, and each gaseous working medium input channel 105 is in communication with the corresponding gaseous working medium output port 102. Such structure enables the heat sink to form a heat dissipation cycle in a plurality of positions, thereby improving the heat dissipation capacity of the heat sink. At the same time, spaced distribution facilitates air circulation between the adjacent condensation portions 200, thereby improving the condensation and heat dissipation capacity. In this case, there may be a plurality of liquid working medium backflow ports 103 and a plurality of gaseous working medium output ports 102, so as to establish a corresponding cooperation relation with the plurality of condensation portions 200 and the isolation portions 300.

In the embodiment of the present application, the condensation portion 200 and the isolation portion 300 may be all regarded as hollow members as long as a heat dissipation structure meeting circulation of the gaseous working medium and the liquid working medium above can be formed. Please refer to FIG. 1, FIG. 4, FIG. 5 and FIG. 6 again, in an optional solution, the condensation portion 200 may include a condensation flat pipe 210 and a second cover plate 220, the isolation portion 300 is of a plate-shaped structure, and as the isolation portion 300 has the gaseous working medium input channel 105, in this case, the isolation portion 300 is actually of a hollow plate-shaped structure. The condensation flat pipe 210 is of a flat structure, and a pipe cavity of the condensation flat pipe 210 is also a flat space. A plate surface of the isolation portion 300 may be parallel to a flat surface of the condensation flat pipe 210, so that the shape of the isolation portion 300 may be better adapted to the condensation flat pipe 210. The condensation flat pipe 210 is of a flat structure, so a smooth heat exchange surface may be easily formed, which facilitates design of a larger heat exchange area and improves heat exchange efficiency. In some cases, the condensation flat pipe 210 enables the condensation portion 200 to be designed into a smaller size in a direction, and thus more arrangements may be conveniently performed in a space determined by the size in the direction of the condensation portion 200.

In such case, the shape of a first strip-shaped port of the condensation flat pipe 210 may match shapes of the gaseous working medium output port 102 and the liquid working medium backflow port 103 (which are all strip-shaped structures), and the first strip-shaped port of the condensation flat pipe 210 is in communication with the gaseous working medium output port 102 and the liquid working medium backflow port 103, the second cover plate 220 covers a second strip-shaped port of the condensation flat pipe 210, the second cover plate 220 and the isolation portion 300 are arranged in a spaced mode, and form a connecting channel 106, the liquid working medium backflow channel 104 is formed between the isolation portion 300 and an inner pipe wall of the condensation flat pipe 210, and the liquid working medium backflow channel 104 is in communication with the gaseous working medium input channel 105 by means of the connecting channel 106. The connecting channel 106 is formed by the second cover plate 220 covering the second strip-shaped port of the condensation flat pipe 210, which is simpler in structure and easier to realize.

In other embodiments, a communication hole may also be formed in the isolation portion 300, and the communication hole replaces the connecting channel 106 to make the liquid working medium backflow channel 104 communicate with the gaseous working medium input channel 105.

In a further technical solution, the liquid working medium backflow channel 104 surrounding the gaseous working medium input channel 105 is formed between the isolation portion 300 and an inner wall of the condensation flat pipe 210, and this surrounding structure facilitates backflow of the liquid working medium. The gaseous working medium output port 102 is a strip-shaped hole whose shape matches the shape of the first strip-shaped port of the condensation flat pipe 210, and shape matching here refers to that they are all strip-shaped structures. Liquid working medium backflow ports 103 are formed in both sides of the gaseous working medium output port 102 in the length direction of the gaseous working medium output port, and the liquid working medium backflow channel 104 are in communication with the both liquid working medium backflow ports 103 located in the both sides of the gaseous working medium output port 102 in the length direction. In this case, the liquid working medium can flow back through the two liquid working medium backflow ports 103, which can improve the backflow efficiency. At the same time, the gaseous working medium output port 102 is a strip-shaped hole and can be adapted to the isolation portion 300 of the plate-shaped structure.

In a case where the isolation portion 300 is of the plate-shaped structure, the gaseous working medium input channel 105 may be of a flat cuboid structure, the width of the gaseous working medium input channel 105 is no less than 0.5 mm, and in some cases, the width of the gaseous working medium input channel 105 refers to the size, in the direction perpendicular to the plate surface of the isolation portion 300, of the plate-shaped structure.

As described above, in a case where there are a plurality of condensation portions 200, the second cover plates 220 of all the condensation portions 200 are connected to form an integrated structure. In this case, the second cover plates 220 of the plurality of condensation portions 200 form the integrated structure, so that during an assembling process, an operator may mount the condensation flat pipes 210 of the plurality of condensation portions 200 onto the base 100 and then use a whole plate to cover ports of all the condensation flat pipes 210, thereby defining the connecting channel 106 with the isolation portion 300 in each condensation flat pipe 210. In this way, assembling is facilitated. The plurality of second cover plates 220 are of the integrated structure, and actually the plurality of condensation portions 200 are connected, which can improve the whole strength of the whole heat sink.

In order to further improve the condensation effect, in the embodiment of the present application, a plurality of fins 500 may be arranged on the outer side surface of the condensation portion 200, and the plurality of fins 500 may be distributed at intervals. Arrangement of the fins 500 can improve the heat exchange capacity of the condensation portion 200 with the environment, which facilitates improving of the condensation capacity.

In an optional solution, there are a plurality of condensation portions 200, the isolation portion 300 is arranged in each condensation portion 200, the plurality of condensation portions 200 are arranged on the base 100 at intervals, and the two adjacent condensation portions 200 are connected through the fins 500 located therebetween. In this case, the condensation portions 200 may be mounted based on the base 100 and meanwhile may be connected through the fins 500, thereby forming a more stable connecting structure and improving the strength of the whole heat sink.

The working medium involved in the embodiment of the present application may be water or oil, and the specific type of which is not limited by the embodiment of the present application.

In the embodiment of the present application, a gap width between the isolation portion 300 and the condensation portion 200 may be greater than 0.5 mm. For fully realizing an effect of cavity partitioning, the height of the isolation portion 300 is optionally greater than 1/2 of the height of the condensation flat pipe 210. At the same time, for avoiding too large flow resistance of the connecting channel 106, the height of the isolation portion 300 is at least 5 mm less than the height of the condensation flat pipe 210. The height here is considered based on the same reference surface on the base 100 (for example, a plane on the base 100, which is used for supporting the condensation portion 200 and the isolation portion 300).

Based on the heat sink disclosed by the embodiment of the present application, an embodiment of the present application further discloses an electronic device, the disclosed electronic device includes a heat source device and a heat sink, a base 100 is arranged on the heat source device, and the heat sink is the heat sink described in any one of the above embodiments.

It needs to be noted that the heat source device here is the object to be heat-dissipated as described above. The heat source device involved in the embodiment of the present application may be a processor in an exchanger, or another device in the electronic device that may produce heat during work, which is not limited by the embodiment of the present application.

The above embodiments of the present application focus on description of differences of the respective embodiments, and different optimized features of the respective embodiments may be combined to form a better embodiment as long as they have no contradiction, which is not described in detail here for the sake of being concise.

The foregoing descriptions are merely embodiments of the present application and are not used for limiting the present application. There may be various modifications and changes of the present application to those skilled in the art. Any modification, equivalent replacement, improvement or the like made within the spirit and principle of the present application shall fall within the scope of the claims of the present application.

## Claims

1. A heat sink, comprising a base (100), a condensation portion (200) and an isolation portion (300), wherein
the base (100) is provided with an evaporation cavity (101), and a gaseous working medium output port (102) and a liquid working medium backflow port (103) which are both in communication with the evaporation cavity;
the isolation portion (300) is provided with a gaseous working medium input channel (105); a first end portion of the gaseous working medium input channel (105) is in communication with the gaseous working medium output port (102); and
the condensation portion (200) is arranged on the base (100), the isolation portion (300) is arranged in the condensation portion (200), a liquid working medium backflow channel (104) is formed between an outer surface of the isolation portion (300) and an inner wall of the condensation portion (200), a second end portion of the gaseous working medium input channel (105) is in communication with a first end portion of the liquid working medium backflow channel (104), a second end portion of the liquid working medium backflow channel (104) is in communication with the liquid working medium backflow port (103), and the isolation portion (300) isolates the gaseous working medium output port (102) from the liquid working medium backflow port (103).

2. The heat sink according to claim 1, wherein the evaporation cavity (101) has a liquid working medium gathering region and an evaporation region, the evaporation region is in communication with the gaseous working medium output port (102), the liquid working medium backflow port (103) is in communication with the liquid working medium gathering region, a capillary structure (400) is arranged in the evaporation region, the base (100) comprises a fence (110), the fence (110) is arranged in the evaporation cavity (101) and around the capillary structure (400), a space defined by the fence (110) is the evaporation region, the gaseous working medium output port (102) is located inside the fence (110), and both the liquid working medium backflow port (103) and the liquid working medium gathering region are located outside the fence (110).

3. The heat sink according to claim 2, wherein the base (100) further comprises a base plate (120) and a first cover plate (130), the base plate (120) is provided with a groove (121), the first cover plate (130) is connected with the base plate (120), the first cover plate (130) covers a groove opening of the groove (121), the first cover plate (130) and the base plate (120) define the evaporation cavity (101), the fence (110) is connected with the first cover plate (130), and the gaseous working medium output port (102) and the liquid working medium backflow port (103) are formed in the first cover plate (130).

4. The heat sink according to claim 3, wherein the base (100) further comprises a plurality of support projections (140) distributed in an array, the plurality of support projections (140) perform supporting between a bottom wall of the groove (121) and the first cover plate (130), the capillary structure (400) is provided with receding holes (410), and the support projections (140) corresponding to the capillary structure (400) are arranged in the corresponding receding holes (410) in a penetrating mode.

5. The heat sink according to claim 4, wherein the support projections (140) and the base plate (120) are of an integrated structure.

6. The heat sink according to claim 1, wherein a plurality of condensation portions (200) and a plurality of isolation portions (300) are arranged and distributed at intervals, the plurality of condensation portions (200) and the plurality of isolation portions (300) are in one-to-one correspondence, so that a plurality of gaseous working medium input channels (105) and a plurality of liquid working medium backflow channels (104) are formed,
the plurality of condensation portions (200) are arranged on the base (100) at intervals, each liquid working medium backflow channel (104) is in communication with the corresponding liquid working medium backflow port (103), and each gaseous working medium input channel (105) is in communication with the corresponding gaseous working medium output port (102).

7. The heat sink according to claim 1, wherein the condensation portion (200) comprises a condensation flat pipe (210) and a second cover plate (220), the isolation portion (300) is of a plate-shaped structure, a plate surface of the isolation portion (300) is parallel to a flat surface of the condensation flat pipe (210), a shape of a first strip-shaped port of the condensation flat pipe (210) matches shapes of the gaseous working medium output port (102) and the liquid working medium backflow port (103), the first strip-shaped port of the condensation flat pipe (210) is in communication with the gaseous working medium output port (102) and the liquid working medium backflow port (103), the second cover plate (220) covers a second strip-shaped port of the condensation flat pipe (210), the second cover plate (220) and the isolation portion (300) are arranged in a spaced mode, and form a connecting channel (106), the liquid working medium backflow channel (104) is formed between the isolation portion (300) and an inner pipe wall of the condensation flat pipe (210), and the liquid working medium backflow channel (104) is in communication with the gaseous working medium input channel (105) by means of the connecting channel (106).

8. The heat sink according to claim 7, wherein the liquid working medium backflow channel (104) surrounding the gaseous working medium input channel (105) is formed between the isolation portion (300) and an inner wall of the condensation flat pipe (210), the gaseous working medium output port (102) is a strip-shaped hole whose shape matches a shape of the first strip-shaped port of the condensation flat pipe (210), liquid working medium backflow ports (103) are formed in both sides of the gaseous working medium output port (102) in a length direction of the gaseous working medium output port, and the liquid working medium backflow channel (104) are in communication with the two liquid working medium backflow ports (103) located in the two sides of the gaseous working medium output port (102) in the length direction.

9. The heat sink according to claim 7 or 8, wherein a plurality of the condensation portions (200) are arranged, and the second cover plates (220) of all the condensation portions (200) are connected and form an integrated structure.

10. The heat sink according to claim 1, wherein a plurality of fins (500) are arranged on an outer side surface of the condensation portion (200), and the plurality of fins (500) are distributed at intervals.

11. The heat sink according to claim 10, wherein a plurality of the condensation portions (200) are arranged, the plurality of condensation portions (200) are arranged on the base (100) at intervals, and the two adjacent condensation portions (200) are connected through the fins (500) located therebetween.

12. An electronic device, comprising a heat source device and a heat sink, a base (100) is arranged on the heat source device, and the heat sink is the heat sink according to any one of claims 1 to 11.
